# FASCICULE DE BREVET EUROPEEN

(11) **EP 1 652 417 B1**
(45) Date de publication et mention de la délivrance du brevet: **02.04.2008**
(21) Numéro de dépôt: 04786227.1
(22) Date de dépôt: 05.08.2004
(51) Int. Cl.: H05K 13/04, H05K 13/02

(54) **PINCE, DISPOSITIF ET METHODE POUR LE POSITIONNEMENT DE COMPOSANTS ELECTRONIQUES**
GREIFER, EINRICHTUNG UND VERFAHREN ZUR POSITIONIERUNG ELEKTRONISCHER DOKUMENTEN
PREHENSOR, DEVICE FOR AND METHOD FOR POSITIONING ELECTRONIC COMPONENTS

(30) Priorité: 08.08.2003 CH 138403
(43) Date de publication de la demande: 03.05.2006
(73) Titulaire: ISMECA Semiconductor Holding SA, 2300 La Chaux-de-Fonds (CH)
(72) Inventeur: DROMARD, Pascal, F-25500 Montlebon (FR); HEINIGER, Laurent, CH-2052 Fontainemelon (CH)
(74) Mandataire: P&TS Patents & Technology Surveys SA
(86) Numéro de dépôt international: PCT/EP2004/051731
(87) Numéro de publication internationale: WO 2005/018299

(56) Documents cités:
- US-A- 4 797 996
- US-A- 4 987 676
- US-A1- 2001 049 873

## Description

La présente invention concerne une pince pour le positionnement de composants électroniques, un dispositif de positionnement comprenant une telle pince, ainsi qu'une méthode pour le positionnement de composants électroniques. La présente invention concerne en particulier une pince, un dispositif et une méthode pour le positionnement de composants électroniques de petite taille lorsde leur traitement par une ligne de traitement automatique, par exemple par une ligne de test et/ou de conditionnement.

Après leur fabrication et avant leur intégration dansun boîtier ou sur un circuit imprimé, par exemple, les composants électroniques sont généralement soumisà destests, électriques ou mécaniques, et/ou à des opérationsde marquage, de conditionnement, etc. Ces opérations sont le plussouvent effectuées par des lignesde traitement automatiques comprenant plusieurs postes de traitement successifs disposés le long d'un convoyeur transportant les composants d'un poste à l'autre.

Le convoyeur transporte les composants électroniques à l'aide de porte-composants, par exemple à l'aide de têtesd'aspiration permettant de prélever et de maintenir les composants par leur face supérieure. Les composantssont ainsi amenéssur les postes de traitement qui effectueront sur eux les opérations pour lesquelles ils sont prévus. La plupart de ces opérations, en particulier les opérations de test électrique, requièrent généralement que le composant soit positionné de manière très précise par rapport au poste de traitement. Cela est particulièrement le cas, par exemple, lors de tests électriques sur de petits composants, par exemple sur des puces électroniques non encapsulées ou sur des petits composants encapsulés sans pattes (LLP), dont la taille des surfacesde contact devant être contactées par la ou lessondesde test est généralement très faible.

Pour permettre ce positionnement précis des composants électroniques, leur position sur le convoyeur doit pouvoir être déterminée avec précision. Lescomposantsdoivent ainsi être positionnésavec précision sur leur porte-composant.

Sur la plupart des lignes de traitement de l'art antérieur, le positionnement descomposantssur les porte-composants se fait lorsde leur introduction sur la ligne. Un poste d'alimentation amène les composants depuis un réservoir vers le convoyeur. Au coursde ce déplacement, les composants sont généralement orientés puis disposés un à un sur un emplacement duquel ils seront prélevés par les porte-composants du convoyeur. Cet emplacement comporte généralement une surface de référence contre laquelle les composants arrivent en butée, déterminant ainsi leur position selon au moins un axe. La précision atteinte à l'aide de tels dispositifs est cependant limitée et parfoisinsuffisante pour permettre le bon déroulement de certaines opérations de test. De plus, la position des composant sur les porte-composants peut varier au coursde leur traitement par la ligne automatique, particulièrement s'ils sont déposéssur plusieurs postes pour y être ensuite prélevé à nouveau, éventuellement par un autre porte-composant que celui qui l'a déposé.

Certains dispositifs de l'art antérieur proposent de résoudre ces problèmesde précision à l'aide de têtesd'aspiration comprenant un élément additionnel permettant le positionnement du composant électronique qu'elles transportent. Cet élément additionnel comprend par exemple despincesde centrage attachéesdirectement à la tête d'aspiration tellesque celles décrites par exemple dans les brevets US5,497,983 et US5,697,658. Ces solutions comportent toutefoisde multiples désavantages, dont :
leur difficulté de réalisation, en particulier pour de très petits composants;
leur coût en raison de la complexité mécanique de chaque tête d'aspiration ;
l'encombrement accru destêtesd'aspiration, rendant par exemple difficile, voire impossible, la dépose descomposantssur certainspostesde traitement.

Une solution plus avantageuse consiste à utiliser un dispositif de positionnement indépendant du porte-composant et comprenant par exemple une ou plusieurs paires de mâchoires, sur lequel le composant à centrer peut être déposé, positionné selon un ou plusieurs axes, puis prélevé à nouveau par exemple par une tête d'aspiration. Le positionnement des composants électroniques peut ainsi être effectuée au moment le plus adéquat de leur traitement.

Le brevet US4,821,393 décrit par exemple un dispositif de centrage comprenant deux pairesde mâchoires pour centrer un composant électroniques selon deux axes. Ce dispositif présente toutefois le désavantage majeur que lesdeux pairesde mâchoires sont fermées alternativement. Dans un premier temps, le composant est centré selon un premier axe, puis, dans un deuxième temps, selon un deuxième axe. Les risquessont ainsi importantsque le centrage effectué par la première paire de mâchoires soit déréglé lorsdu centrage par la deuxième paire de mâchoires. Un tel dispositif ne permet donc pasde garantir un positionnement précis des composants selon deux axes. Il ne permet pas en particulier d'atteindre une précision suffisante pour le positionnement de composants électroniques de petite taille.

De plus, le centrage de chaque composant nécessite deux mouvements d'actionnement successifs distincts. Chaque paire de mâchoires étant actionnée par une vis de guidage nécessitant plusieurs tourscompletsavant que les mâchoires n'entrent en contact avec le composant, ces mouvementsd'actionnement sont également lents. Le temps nécessaire au positionnement d'un composant par un tel dispositif est donc élevé, rendant impossible son intégration à une ligne automatique de traitement des composants électroniques sans en impacter fortement la cadence et donc en péjorer significativement les performances.

Un but de l'invention est de proposer un dispositif pour le positionnement de composants électroniques évitant les inconvénients des dispositifsde l'art antérieur.

Un autre but de l'invention est de proposer un dispositif permettant le positionnement rapide et précis de composants électroniques au cours de leur traitement par une ligne automatique.

Encore un but de l'invention est de proposer une méthode pour le positionnement rapide et précis de composantsélectroniquesau coursde leur traitement par une ligne de traitement automatique.

Ces buts sont atteints par une pince, un dispositif et une méthode pour le positionnement de composants électroniques possédant les caractéristiques des revendications indépendantes correspondantes, des variantes préférentielles étant don nées par les revendications dépendantes.

Cesbutssont atteints en particulier par une pince pour le positionnement de composants électroniques, comprenant un support et un élément mobile comprenant une partie d'actionnement, l'élément mobile comprenant au moinstrois mâchoires permettant de contacter mécaniquement un composant électronique en au moinstroispoints d'appui et selon au moinsdeux directionsnon parallèles entre elles pour le positionner par rapport au support dans un plan de positionnement, la pince étant actionnée par un mouvement linéaire de la partie d'actionnement par rapport au support selon un axe d'actionnement parallèle au plan de positionnement.

Ces buts sont également atteints en particulier par un dispositif pour le positionnement de composant électroniques comprenant une telle pince et un actuateur pour l'actionnement automatique de la pince.

Ces buts sont également atteints en particulier par une méthode pour le positionnement de composants électroniques, comprenant les étapes suivantes:
dépose d'un composant électronique sur une pince de positionnement,
positionnement du composant électronique dansun plan de positionnement par la pince en contact mécanique avec le composant électronique en au moins trois points d'appui et et selon au moinsdeux directions non parallèlesentre elles,
prélèvement du composant électronique de la pince,
le prélèvement du composant électronique étant effectué au même emplacement que sa dépose.

La pince de l'invention est ainsi très compacte car toutes ses parties mobiles se déplacent dansun seul plan et son actionnement linéaire peut être effectué automatiquement par des mécanismesd'actionnement relativement simples De plus, les composants étant déposéset prélevés au même endroit sur la pince, cette dernière est particulièrement adaptée à une intégration sur une ligne de traitement automatique.

La présente invention sera mieux comprise à la lumière de la description de variantes préférentielles illustrées par les figures 1 à 5, où:
la figure 1 représente une pince de positionnement selon une version préférentielle de l'invention en position ouverte,
la figure 2 représente la pince de la figure 1 en position fermée,
la figure 3 représente une pince de positionnement selon une autre version préférentielle de l'invention,
la figure 4 représente une pince de positionnement selon encore une autre version préférentielle de l'invention,
la figure 5 représente une vue partielle d'un dispositif de positionnement selon une version préférentielle de l'invention.

La pince de l'invention est de préférence adaptée au positionnement de composantsélectroniquesde petite taille, en particulier au positionnement de puces électroniques non encapsulées, c'est-à-dire de composantsen un matériau semiconducteur, en général en silicium, non protégés par un boîtier. Ces composants sont fragileset requièrent donc un soin particulier lorsde leur manipulation. De plus, en raison de leur petite taille, leur positionnement doit être très précis.

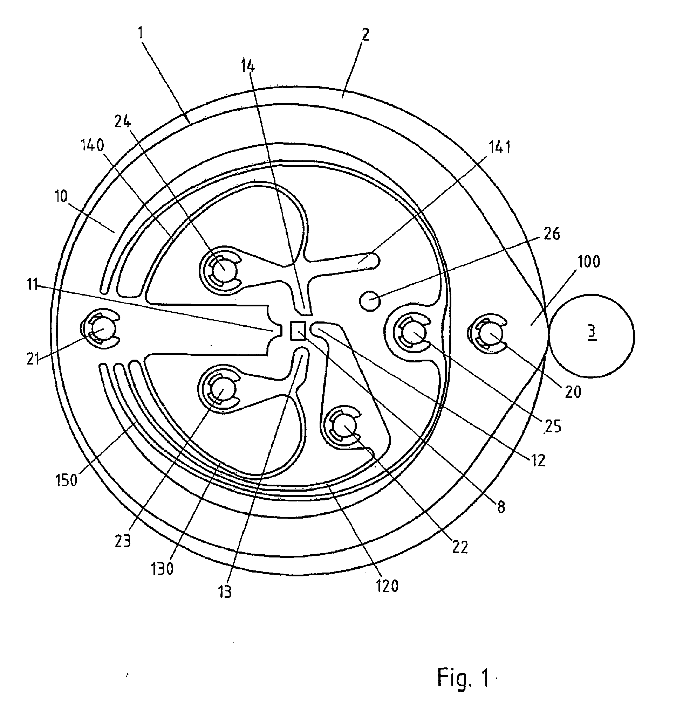

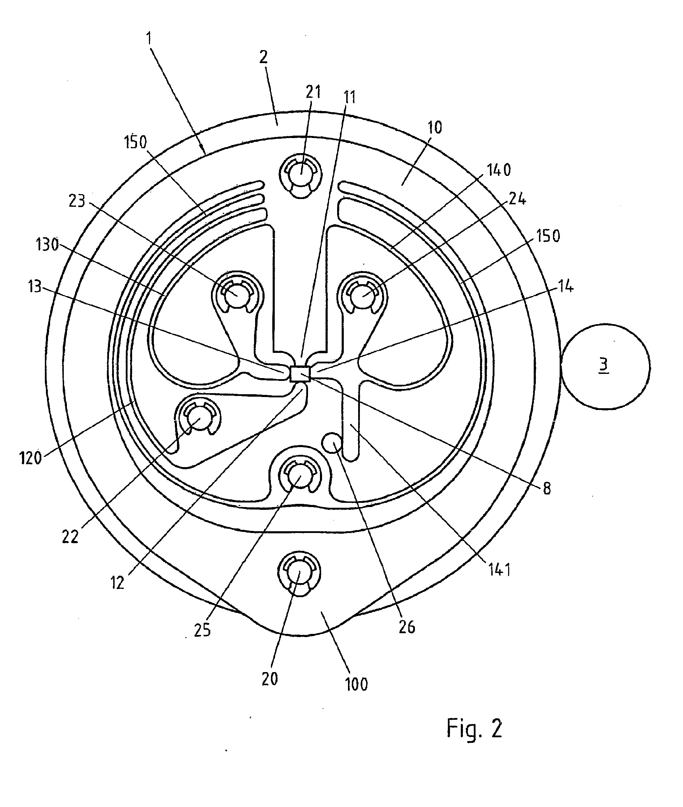

En référence aux figures 1 et 2, la pince de l'invention comprend un élément mobile 1 et un support 2. Le support 2 comporte de préférence une surface plane sur laquelle est fixée l'élément mobile essentiellement plat, de préférence d'une épaisseur sensiblement égale à celle des composants électroniques à positionner. La pince de l'invention forme ainsi de préférence un ensemble essentiellement plat et de faible épaisseur, adapté au positionnement de très petits composants électroniques.

L'élément mobile 1 comprend par exemple quatre mâchoires 11, 12, 13, 14 réparties par paires 11-12 et 13-14 et une partie permettant l'actionnement de la pince. La partie d'actionnement est par exemple constituée d'un cadre 10 rigide de forme circulaire et entourant les quatre mâchoires 11, 12, 13, 14. Il permet, ainsi qu'expliqué plus bas, l'actionnement de la pince par son déplacement linéaire par rapport au support 2 sous l'effet d'une force extérieure.

L'élément mobile 1 est attaché en plusieurs points au support 2 à l'aide d'éléments fixes de ce dernier, par exemple à l'aide de tenons cylindriques20, 21, 22, 23, 24 et 25 chassésou formés sur le support 2, de préférence sur sa surface supérieure et plane. Lorsque l'élément mobile 1 est placé sur le support 2, les tenons 20, 21, 22, 23, 24 et 25 sont insérés dansdesouverturesprévuesàcet effet dans diverses parties de l'élément mobile 1. Afin de maintenir ce dernier contre le support 2, par exemple des clips représentés sur les figures 1 et 2, mais non référencéspour des raisons de lisibilité, sont inséréssur chaque tenon 20, 21, 22, 23, 24 et 25 dansune gorge prévue à cet effet, empêchant ainsi tout mouvement indésirable des partiescorrespondantesde l'élément mobile 1 perpendiculairement à la surface supérieure du support 2, tout en permettant leur translation et/ou rotation dans un plan parallèle à cette même surface.

Le cadre 10 de l'élément mobile 1 comporte de préférence deux ouvertures allongées, par exemple ovales, orientées parallèlement l'une par rapport à l'autre. Dans chacune de ces deux ouvertures allongée est inséré un tenon cylindrique 20, resp. 21. Comme expliqué plus haut, le cadre 10 est maintenu contre la surface supérieure du support 2 par exemple par des clipsfixéssur ces deux tenons 20, 21. Les ouvertures allongées et lestenons 20, 21 sont dimensionnés de manière à permettre un déplacement du cadre 10 sur le support 2 selon un axe linéaire parallèle à l'axe longitudinal des ouvertures allongées, tout en empêchant tout déplacement dansune autre direction. L'amplitude de ce déplacement linéaire par rapport au support 2 est déterminée par la longueur des ouvertures allongées du cadre 10. Comme il sera expliqué plusloin, lorsque le cadre 10 se trouve à une extrémité de son déplacement linéaire, la pince est ouverte (Fig. 1) tandis qu'elle est fermée lorsque le cadre 10 se trouve à l'extrémité opposée de ce même déplacement linéaire (Fig. 2).

Un ou plusieurs éléments élastiques ramènent avec une certai ne force le cadre 10 versune position de reposdéterminée correspondant de préférence à une desextrémitésde son déplacement linéaire. Selon une version de l'invention, ces éléments élastiques sont deux lames ressort 150 reliant le cadre 10 à un tenon 25 fixe par rapport au support 2 et le ramenant versune position de repos correspondant à la position fermée de la pi nce.

Les mâchoires 11, 12, 13, 14 se trouvent à l'intérieur du périmètre délimité par le cadre 10. Une première mâchoire 11 de l'élément mobile 1 est de préférence fixe par rapport au cadre 10, de sorte que ses mouvements sont identiques à ceux de ce dernier. Cette première mâchoire 11 se déplace ainsi selon un axe parallèle à l'axe d'actionnement de la pince. Lestroisautres mâchoires 12, 13, 14 sont maintenues en rotation, chacune autour d'un tenon 22, 23, resp. 24 fixe par rapport au support 2. Les mâchoires 12, 13, 14 et les tenons 22, 23, 24 sont de préférence disposés de sorte que la mâchoire 12 faisant partie de la même paire que la première mâchoire 11 entre également en contact avec le composant à centrer 8 selon une direction parallèle à l'axe d'actionnement de la pince, tandisque les mâchoires 13, 14 de l'autre paire entrent en contact avec le composant 8 selon une direction sensiblement perpendiculaire à l'axe d'actionnement de la pince. Des clips fixés sur lestenons22, 23, 24 empêchent par exemple tout mouvement indésirable des mâchoires 12, 13, 14 perpendiculairement à la surface supérieure du support 2. Les mâchoires 12, 13, 14 sont reliées au cadre rigide 10 par exemple par des éléments élastiques, par exemple par des lames ressort 120, 130, 140.

La pince de l'invention est actionnée de préférence par l'intermédiaire de son cadre 10 qui comprend par exemple une languette 100 prévue à cet effet. Selon une version préférentielle, la languette 100 est saillante par rapport au support 2 lorsque la pince est en position de repos, par exemple fermée (fig. 2), et ramenée vers le centre de la pince lorsque cette dernière est ouverte, facilitant ainsi son actionnement à l'aide d'un élément mécanique placé à proximité de la pince, par exemple à l'aide d'une tige 3, comprenant de préférence sur sa partie supérieure un galet en rotation libre autour de son centre, dont la disposition et la fonction seront expliquées plus en détail plus bas.

Ainsi, par l'application sur la languette 100 d'une force suffisante agissant contre la force de retour générée par les lames ressort 150, le cadre 10 est écarté de sa position de reposet est déplacé par rapport au support 2 dans un mouvement linéaire parallèle à l'axe longitudinal de ses ouvertures allongées Les lames ressort 150 sont alors tendues et les mâchoires 11, 12, 13 et 14 sont écartées les unes des autres, offrant suffisamment de place libre sur le support 2 au centre de la pince pour y déposer par exemple un composant électronique 8 à positionner. La première mâchoire 11, mécaniquement solidaire du cadre 10, est déplacée selon un mouvement linéaire identique à celui de ce dernier. Lesautres mâchoires 12, 13, 14 sont entraînées dans un mouvement de rotation autour de leur tenon 22, 23, 24 respectif sous la traction de la lame ressort 120, 130, 140 correspondante dont une extrémité est attachée au cadre 10, de préférence du côté opposé à la languette 100.

Aprèsqu'un composant électronique 8 a été déposé sur le support 2 au centre de la pince, la force appliquée sur le cadre 10 pour la maintenir ouverte est réduite ou éliminée et la pince est ramenée verssa position de repossous la force des lames ressort 150. Les mâchoires 11, 12, 13, 14 reviennent alors vers le centre de la pince, dans un mouvement linéaire parallèle à l'axe de déplacement du cadre 10 pour la première mâchoire 11, ou dansun mouvement de rotation autour du tenon 22, 23, 24 respectif induit par la force d'appui élastique de la lame ressort correspondante 120, 130, 140 pour les trois autres mâchoires 12, 13, 14. Ainsi qu'expliqué précédemment, le mouvement des trois autres mâchoires 12, 13, 14 est de préférence déterminé de sorte que, au moment d'entrer en contact avec le composant à positionner 8, la direction du déplacement de la mâchoire 12 faisant partie de la même paire que la première mâchoire 11 est sensiblement parallèle à l'axe d'actionnement de la pince, tandis que la direction du déplacement des deux autres mâchoires 13, 14 est sensiblement perpendiculaire à l'axe d'actionnement.

Lorsde la fermeture de la pince, chaque paire de mâchoires détermine la position du composant 8 sur le support 2 selon un axe parallèle au plan de la surface supérieure de ce dernier. Sous l'effet d'un seul déplacement linéaire du cadre 10, le composant 8 est ainsi positionné avec précision, selon deux axes de préférence perpendiculaires entre eux, sur le plan de positionnement défini par la surface supérieure du support 2. Au cours de ce positionnement, le composant électronique 8 est contacté mécaniquement en au moinstrois pointsd'appui par les mâchoires 11 et 12, 13 et 14, de préférence en quatre pointsd'appui distincts situés sur ses faces latérales.

De préférence, la force de retour générée par les lames ressort 150, 120, 130, 140 n'est pasidentique pour chaque mâchoire 11, 12, 13, 14. Chaque paire comprend ainsi une mâchoire de référence 11, resp. 14 exerçant sur le composant 8 à positionner lors de la fermeture de la pince une force plus élevée que celle exercée par l'autre mâchoire 12, resp. 13 de la même paire. Le mouvement de retour de chaque mâchoire de référence 11, resp. 14 vers la position fermée de la pince est de préférence limité par un ou plusieurs élémentsde butée, par exemple par les tenons 20 et 21, resp. 26, définissant une position de référence précise et reproductible de la mâchoire 11, resp. 14 lorsque la pince est fermée. Danscette position, le composant 8 est fermement appuyé par ses faces latérales contre les mâchoiresde référence 11, 14 dans leur position de référence par les deux autres mâchoires 12 et 13, garantissant ainsi son positionnement précis.

Selon une variante de l'invention, lesmâchoiresde référence 11, 14 sont remplacées par des éléments fixes par rapport au support 2 contre lesquels le composant est par exemple plaqué sous la force d'appui élastique de deux mâchoires mobiles.

Un avantage de la version de l'invention décrite précédemment réside cependant dans le fait que, les mâchoires de référence 11, 14 s'écartant lorsque la pince est ouverte, le composant 8 à positionner peut être déposé au centre de cette dernière quelle que soit la précision de sa position initiale sans risquer d'entrer involontairement en contact avec une des mâchoiresde référence 11, 14. Le composant 8 à positionner peut ainsi être déposé sur la pince au même endroit que celui d'où il sera prélevé aprèsson positionnement, évitant ainsi à un porte-composant et/ou à la pince d'effectuer un déplacement supplémentaire entre cesdeux actions.

Il est également envisageable dans le cadre de l'invention de configurer la pince en sorte que lesquatre mâchoires soient maintenues en rotation autour d'un tenon et reliées au cadre par des éléments élastiques. Il est alors possible de dimensionner les éléments élastiques de sorte que les deux mâchoiresd'une même paire appuient avec sensiblement la même force sur le composant à positionner. Idéalement, le composant se retrouve alors parfaitement centré sur la pince. Une telle variante de l'invention est cependant plus délicate à réaliser que la variante décrite plus haut car de faibles différences entre lesforces exercées par les mâchoires d'une même paire peuvent générer des imprécisions sensibles sur le centrage du composant. Ces différences peuvent par exemple être duesà un défaut de précision lorsde la fabrication de la pince ou à la fatigue des éléments élastiques.

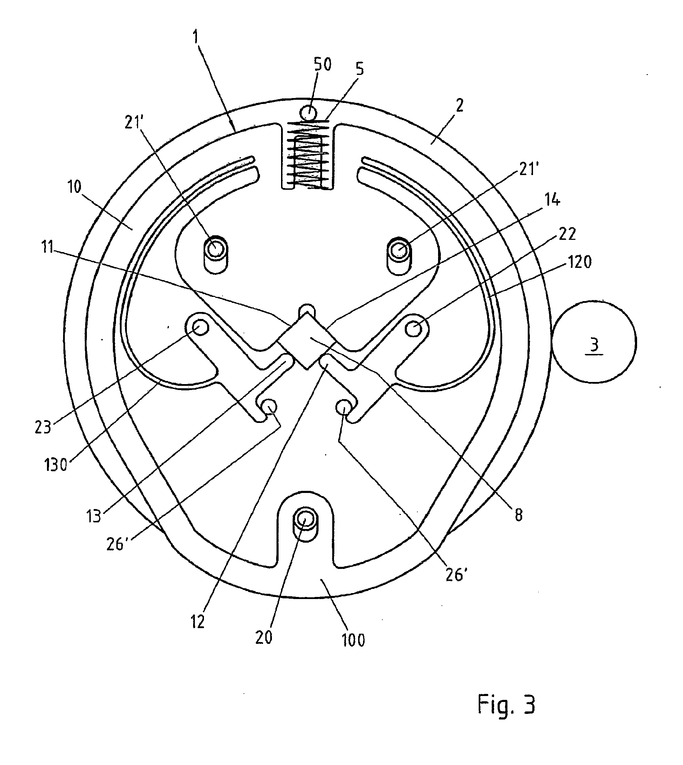

La figure 3 illustre une variante de la pince de l'invention dans laquelle lesmâchoiresde référence 11, 14 sont toutes deux solidaires du cadre 10 tandis que les mâchoires 12, 13 plaquant le composant 8 à positionner contre elles sont reliéesau cadre par des lames ressort 120, 130, selon le principe évoqué précédemment. Salon la variante illustrée, le mouvement des mâchoires 12, 13 est au moins partiellement contrôlé par des tenons 26' limitant par exemple l'amplitude de leur mouvement de retour lorsque la pince est fermée, en particulier si aucun composant 8 ne se trouve au centre de la pince.

En outre, selon la variante illustrée, l'élément élastique ramenant avec une certaine force le cadre 10 vers une position de repos déterminée est un ressort 5 maintenu en compression entre le cadre 10 et un tenon 50 formé ou inséré sur la surface du support 2. Le ressort 5 et le tenon 50 sont de préférence disposés de sorte que le ressort 5 exerce sur le cadre 10 une force le ramenant vers une position de repos correspondant à la position fermée de la pince. Un avantage de l'utilisation d'un ressort 5 est que la force de retour du cadre 10 est facilement déterminable, voire ajustable, par le remplacement du ressort 5 par un ressort ayant un coefficient différent.

Selon les versions de l'invention illustrées aux figure 1, 2 et 3, l'élément mobile 1 est constitué d'une seule pièce formée, par exemple par découpage et/ou par étampage, à partir d'une plaque métallique, par exemple à partir d'une plaque d'acier ressort d'une épaisseur de 0,3 à 0,6 mm, l'épaisseur de la plaque métallique, et donc de l'élément mobile 1, étant de préférence sensiblement identique à l'épaisseur des composants électroniques 8 à positionner.

L'élément mobile 1 peut également être constitué d'une pièce moulée, par exemple en métal ou en une matière plastique, dont l'épaisseur est alors également de préférence sensiblement identique à l'épaisseur des composants électroniques 8 à positionner.

Il est également envisageable, dans le cadre de l'invention, d'imaginer un élément mobile 1 formé de plusieurs piècesdistinctes, par exemple d'un cadre et de mâchoires fabriqués séparément et reliés entre eux par exemple par des éléments élastiques qui leur sont attachés, par exemple soudés, ou qui sont maintenus ensemble par d'autres moyens mécaniques, par exemple amovibles.

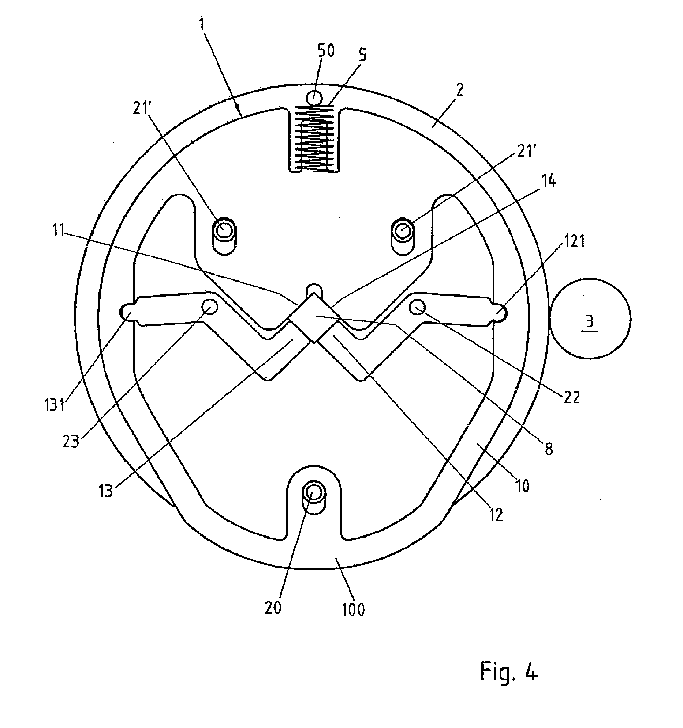

La figure 4 illustre ainsi une pince selon encore une autre variante de l'invention, possédant deux mâchoires de référence 11, 14 solidairesdu cadre rigide 10 et formées par exemple dansla même pièce que ce dernier, et deux mâchoires 12, 13 pour plaquer le composant 8 à positionner contre lesmâchoiresde référence 11,14 lorsque la pince est fermée. Selon cette variante, les mâchoires 12, 13 sont formées sur des pièces distinctesdu cadre 10 et reliées à ce dernier par une de leur extrémité afin d'être entraînée par ses mouvements lorsde la fermeture et de l'ouverture de la pince. Chacune des pièces comprenant les mâchoire 12, resp.13 est par exemple reliée au cadre 10 par une articulation formée par exemple par une partie saillante 121, resp. 131 insérée dans un logement adéquat du cadre 10. La forme des parties saillantes 121,131 et des logements respectifs est déterminée de sorte que lorsque le cadre 10 est en mouvement, par exemple sous l'effet d'une force exercée sur la languette 100, les mâchoires 12, 13 sont entraînéesen rotation autour de leur tenon respectif 22, 23, ouvrant et fermant ainsi la pince de l'invention.

Un avantage la variante de l'invention illustrée à la figure 4 est que la force de retour de chaque mâchoire 11, 12, 13 et 14 est connue et déterminable avec précision. En effet, l'utilisation de préférence d'un ressort 5 pour ramener le cadre 10 danssa position de repos permet, ainsi qu'expliqué plus haut, de déterminer voire d'ajuster facilement la force de retour desmâchoiresde référence 11, 14. En outre, les mâchoires 12, 13 étant reliées au cadre 10 par une articulation essentiellement rigide, la force exercée sur chacune de ces mâchoires 12, 13 est une fraction déterminée de la force de retour du cadre 10 exercée par le ressort 5, dépendant essentiellement de la géométrie de l'élément mobile 1. Par le contrôle et l'ajustement de la force du ressort 5, la force exercée par chaque mâchoire 11, 12, 13 et 14 sur le composant 8 à positionner peut ainsi être déterminée et ajustée avec précision. Cette force peut en particulier être adaptée à la solidité, le matériau, la taille ou d'autres caractéristiques mécanique du composant 8 à positionner.

L'amplitude des mouvementsdu cadre 10 est limitée par les tenons 20, 21' insérés dans les ouvertures oblongues correspondantes du cadre 10. Les mâchoires 12, 13 étant reliéesau cadre 10 par une articulation essentiellement rigide, leur mouvement est également limité de la même manière. Le mouvement de fermeture de la pince est ainsi limité par l'appui des mâchoires 11, 12, 13, 14 contre les faces du composant 8 à positionner et/ou par l'appui du cadre 10 contre les tenons 20, 21'.

Les pièces comprenant les mâchoires 12, 13 sont de préférence formées par un procédé similaire à celui utilisé pour la formation du cadre 10. Le cadre 10 et les pièces comprenant les mâchoires 12, 13 sont par exemple tousforméspar étampage d'une même plaque métallique, ou de plaques métalliques de même épaisseur.

Selon la variante illustrée, les pièces comprenant les mâchoires 12, 13 sont positionnées sur le support 2 autour des tenons 22, 23 servant également d'axe de rotation à leur mouvement lorsde l'ouverture ou de la fermeture de la pince. Le cadre 10 et les pièces comprenant les mâchoires 12, 13 sont alors par exemple maintenussur le support par une pièce de fixation non représentée fixée sur le support 2 et recouvrant entièrement l'élément mobile 1, à l'exception du centre de la pince où sont déposés les composants 8 à positionner et de la languette 100 permettant l'actionnement de la pince. La pièce de fixation est par exemple une plaque métallique fixée par dessus l'élément mobile 1, évitant ainsi que les pièces qui le constituent ne sortent destenons 20, 21', 22 et 23.

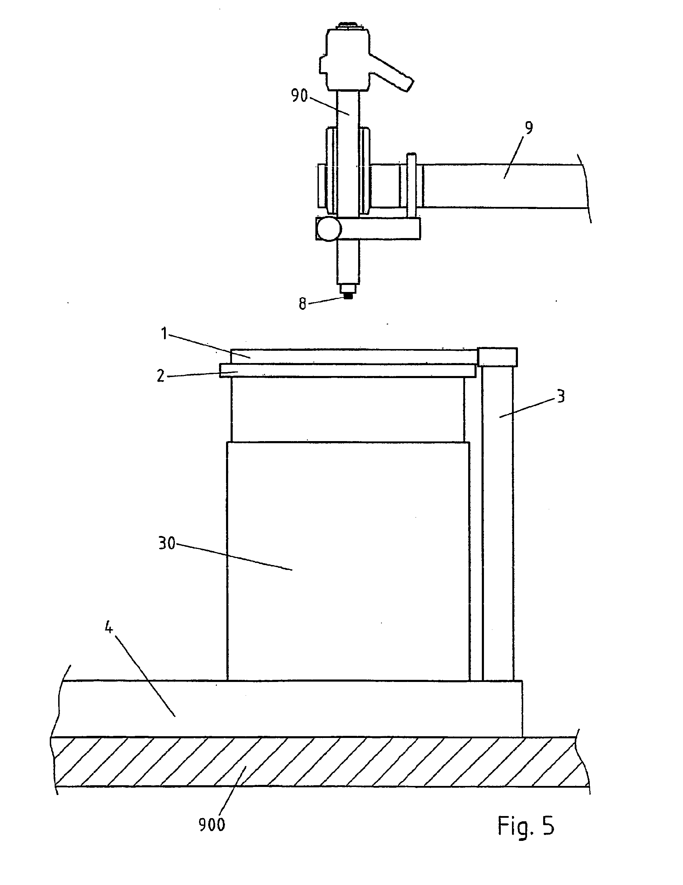

En référence à la figure 5, la pince 1, 2 de l'invention est par exemple intégrée à un dispositif pour le positionnement de composants électroniques8 au coursde leur traitement par une ligne de traitement automatique.

La ligne de traitement automatique comprend par exemple une série de postes de traitement, dont seul le dispositif de positionnement est partiellement représenté à la figure 3, disposésautour d'un convoyeur circulaire 9 équipé de porte-composants permettant de transporter les composants électroniques 8 à traiter d'un poste à l'autre. Les porte-composantssont par exemple des têtes d'aspiration 90 prélevant et transportant les composants électroniques 8 par vide d'air. Les têtes d'aspiration sont reliées à un système pneumatique non représenté et commandé de préférence par le système de contrôle également non représenté du convoyeur circulaire et/ou de la ligne de traitement.

Les postes de traitement sont de préférence fixés sur un plateau fixe 900 situé sous le convoyeur 9 et partiellement représenté en coupe à la figure 3. Le dispositif de positionnement est ainsi de préférence disposé sur une plaque de base 4 comprenant des élémentsde fixation non représentés permettant sa fixation dansune position prédéterminée et précise sur le plateau fixe 900. La position de la pince 1, 2 par rapport aux porte-composants 90 déposant et/ou prélevant les composants électroniques 8 sur le dispositif de positionnement est ainsi parfaitement connue. Cette position est de préférence déterminée de sorte que lescomposants électroniques 8 prélevés après leur positionnement se retrouvent sensiblement au centre du porte-composant 90 correspondant.

Selon une version préférentielle du dispositif de positionnement, la pince 1, 2 est fixée sur un élément rotatif, par exemple sur le rotor d'un moteur rotatif pas-à-pas 30 dont le stator est fixe par rapport à la plaque de base 4. Un élément fixe et rigide, par exemple une tige 3 métallique est fixée sensiblement verticalement sur la plaque de base 4, à proximité de la pince 1, 2. La tige 3 est placée de préférence contre le périmètre du support 2 de la pince, de sorte que suivant la position angulaire de cette dernière, il exerce une pression sur la languette 100 du cadre 10 ayant pour effet l'ouverture de la pince (cf. Figure 1). Cette dernière est ainsi actionnée par sa rotation par rapport à la plaque de base 4.

Pour éviter les frottementsentre la languette 100 et la tige 3 lors de l'actionnement de la pince, la partie supérieure au moinsde la tige 3 est de préférence en rotation libre autour de son axe longitudinal. La tige 3 comprend ainsi par exemple sur sa partie supérieure un galet pouvant entrer en rotation autour de son centre, de sorte que l'appui de la tige 3 contre la languette 100 se fasse au traversde cette partie rotative.

Avant la dépose par un porte-composant 90 d'un composant électronique 8 à positionner, la pince est ouverte. Elle est alors amenée par le moteur 30 dans la position angulaire illustrée à la figure 1. Dans cette position, la tige 3 appuie sur la languette 100, ouvrant ainsi la pince et permettant la dépose d'un composant 8 en son centre. Une fois le composant 8 déposé sur le support 2, le moteur rotatif 30 est actionné pour tourner la pince par exemple d'un quart de tour dans le sens des aiguilles d'une montre, amenant ainsi cette dernière dans la position illustrée à la figure 2. Au cours de ce mouvement de rotation, les mâchoires 11, 12, 13, 14 sont ramenéesvers le centre de la pince selon le principe expliqué plus haut, amenant le composant 8 dans la position recherchée. La pince est alors à nouveau tournée d'un quart de tour, maisdans le sensopposé, écartant les mâchoires 11, 12, 13, 14 du composant 8 positionné qui peut ainsi être prélevé par un porte-composant 90 de la ligne de traitement. L'homme du métier comprendra certainement que la pince peut également être tournée selon des angles différents que des quarts de tour. En particulier, afin d'éviter les mouvementsde va-et-vient du moteur rotatif 30 et de la pince, cette dernière peut par exemple être tournée de deux demi-tours, permettant ainsi le prélèvement du composant électronique positionné danssa position angulaire initiale, sans nécessiter des mouvementsdu moteur dansdeux directionsdifférentes.

Selon un variante non représentée de l'invention, le dispositif de positionnement comprend deux éléments mécaniques pour l'actionnement de la pince, par exemple deux tiges3, disposés dans des positions opposées contre le périmètre du support 2 de la pince. La pince possède alorsdeux positions angulaires séparées d'un demi-tour auxquelleselle est ouverte. Selon cette variante, la pince peut être ouverte dansune première position angulaire avant la dépose du composant à positionner, tournée d'un quart de tour dans une direction pour être refermée et ainsi positionner le composant, puistournée à nouveau d'un quart de tour dans la même direction pour être à nouveau ouverte et permettre le prélèvement par la ligne de traitement du composant positionné, ce dernier se trouvant alors tourné d'un demi-tour par rapport à sa position initiale. Selon cette variante, le dispositif de l'invention permet alors le positionnement et la rotation simultanés du composant électronique, une telle rotation pouvant par exemple être requise pour permettre l'accès à certains postes de traitement à des parties spécifiques du composant.

L'homme du métier comprendra que le nombre et la disposition contre le périmètre du support de la pince des éléments mécaniques permettant l'ouverture de la pince peuvent être ainsi variés de manière à permettre des rotations d'angles différents Le dispositif de positionnement peut par exemple comprendre quatre éléments mécaniques distincts, par exemple quatre tiges rigides, permettant ainsi de prélever le composant positionné après une rotation d'un quart de tour de la pince.

L'homme du métier comprendra également que la pince peut, dans le cadre de l'invention, être également actionnée par des mouvements linéairesde la pince en direction du ou deséléments mécaniques permettant son actionnement, ou par une combinaison de mouvements linéaires et rotatifs.

Afin d'éviter tout déplacement indésirable du composant 8 lors des mouvementsde la pince, en particulier lorsde sa réouverture une fois le composant 8 positionné, la base 2 comprend de préférence une buse non représentée, située sous le composant 8 lorsque ce dernier est correctement positionné, par laquelle de l'air peut être aspiré pour plaquer le composant 8 contre la surface supérieure de la base 2. L'aspiration d'air à travers la buse est de préférence commandée par le système de contrôle du dispositif de positionnement et/ou de la ligne de traitement, permettant ainsi sa coordination avec lesmouvementsde la pince et/ou des porte-composants 90. Ainsi, lorsde la dépose d'un composant sur la pince ouverte, de l'air est par exemple aspiré à travers la buse afin de plaquer immédiatement le composant 8 contre la base 2. Lorsdu positionnement du composant, c'est-à-dire au coursde la fermeture de la pince, l'aspiration est de préférence réduite pour permettre le déplacement du composant sur la surface supérieure de la base 2. L'aspiration est à nouveau augmentée lorsque le composant 8 est dans la position désirée, afin d'éviter tout déplacement de ce dernier par rapport à la base 2 lorsde la réouverture de la pince. Une fois la pince ouverte, l'aspiration est de préférence arrêtée lorsde son prélèvement par la tête d'aspiration 90. Selon une version préférentielle de l'invention, une courte impulsion d'air comprimé est alors expulsée par la buse afin d'assurer le décollage du composant 8 de la surface supérieure de la base 2.

Selon lesvariantesde l'invention décrites plus haut, la pince est actionnée par son mouvement, par exemple sa rotation, par rapport à un ou plusieurs éléments mécaniques 3 fixes exerçant une pression sur la languette 100 suivant la position de la pince. Il est cependant également envisageable, dansle cadre de l'invention, d'actionner la pince, fixe par rapport à la plaque de base du dispositif, à l'aide d'un élément mécanique en mouvement, par exemple selon un mouvement linéaire et/ou de rotation. Une telle forme d'exécution, si elle ne permet pas la rotation du composant au coursde son positionnement, présente l'avantage qu'elle permet d'éviter l'utilisation de moyens par exemple pneumatiques afin de maintenir le composant sur la pince, et que le mouvement de l'élément mécanique actionnant la pince est souvent plus facile à réaliser et nécessite une précision moindre que le mouvement de la pince elle-même. La pince peut ainsi par exemple être fixe sur la plaque de base 4 du dispositif, tandis que la tige 3 ou tout autre élément mécanique de préférence rigide est amené par un mouvement linéaire en direction de la languette 100.

Selon une variante préférentielle, la pince est ainsi actionnée à l'aide d'un cylindre en rotation autour de son axe longitudinal, actionné par exemple à l'aide d'un moteur rotatif pas-à-pas. Sur la partie supérieure du cylindre est disposé par exemple un galet, en rotation autour d'un axe parallèle et excentré par rapport à l'axe de rotation du cylindre. Le galet est alorsdisposé de telle manière que suivant la position angulaire du cylindre, il appuie sur la languette 100, ouvrant ainsi la pince.

Les mécanismes d'action nement de la pince décrits plus hauts sont donnés à titre d'exemples illustratifs, mais non limitatifs. L'homme du métier comprendra en effet que la pince de l'invention peut être actionnée par des mouvements linéaires et/ou rotatifs d'éléments mécaniques et/ou de la pince, muspar exemple à l'aide d'un ou de plusieurs moteurs rotatifs pas-à-pas, vérins pneumatiques, moteurs rotatifs et/ou linéaires électromagnétiques, ou une combinaison de ces moyens, certaines de ces variantes d'exécution pouvant toutefois présenter certains inconvénients par rapport aux exemples décrits plus haut, notamment en terme de simplicité, de robustesse et de cadence de travail.

Ainsi qu'expliqué précédemment, la pince de l'invention est de préférence adaptée au positionnement de petits composants électroniques, en particulier au positionnement de puces électroniques non encapsulées qui sont des composants fragiles. Afin d'éviter tout endommagement des composants lors de leur positionnement, les mâchoires 11, 12, 13 et 14 sont de préférence formées de manière à entrer en contact uniquement avec la partie centrale desfaces latérales des composants, évitant tout appui contre lescoins ou lesarêtesde cesderniersqui sont particulièrement délicats.

La pince de l'invention comprend ainsi quatre mâchoires 11, 12, 13 et 14 réparties par paireset appuyant chacune sur une desquatre faces latéralesdu composant 8 afin de positionner ce dernier selon deux axes dans le plan de positionnement défini par le support 2 sur lequel il repose, la configuration de la pince permettant en outre son actionnement à l'aide d'un seul mouvement linéaire selon un axe d'actionnement unique.

L'homme du métier comprendra cependant qu'il serait également envisageable, dans le cadre de l'invention, de configurer les mâchoiresde manière à ce que leur appui sur le composant à positionner soit différent. Il serait notamment possible de configurer une ou plusieurs mâchoires pour appuyer simultanément sur deux facesdu composant à positionner, permettant éventuellement une réduction du nombre de mâchoires nécessaires à son positionnement selon deux axes.

Il serait également envisageable de concevoir une pince ne comprenant qu'une seule paire de mâchoires pour le positionnement des composants selon un seul axe.

## Revendications

1. Pince pour le positionnement de composants électroniques, comprenant un support (2) et un élément mobile (1) comprenant une partie d'actionnement (10),
ledit élément mobile (1) comprenant au moinstroismâchoires (11, 12, 13, 14) permettant de contacter mécaniquement un composant électronique (8) en au moinstroispointsd'appui et selon au moinsdeux directions non parallèles entre elles pour positionner ledit composant électronique (8) par rapport audit support (2) dans un plan de positionnement,
ladite pince étant actionnée par un mouvement linéaire de ladite partie d'actionnement (10) par rapport audit support (2) selon un axe d'actionnement parallèle audit plan de positionnement.

2. Pince selon la revendication précédente, au moins une desdites deux directions non parallèles entre elles étant parallèle audit axe d'actionnement.

3. Pince selon l'une des revendications précédentes, ledit support (2) permettant de déterminer la position dudit composant électronique (8) selon un axe perpendiculaire audit plan de positionnement.

4. Pince selon la revendication précédente, ledit support (2) comprenant une surface de repos sensiblement plane définissant ledit plan de positionnement.

5. Pince selon l'une des revendications précédentes, ledit élément mobile (1) permettant de contacter mécaniquement ledit composant électronique en quatre pointsd'appui.

6. Pince selon la revendication précédente, ledit élément mobile (1) comprenant quatre mâchoires (11, 12, 13, 14) pour contacter mécaniquement ledit composant électronique (8) en quatre pointsd'appui.

7. Pince selon l'une desrevendicationsprécédentes, au moinsune desdites au moins trois mâchoires (12,13,14) étant reliée à ladite partie d'actionnement (10) par un élément élastique (120, 130, 140).

8. Pince selon la revendication précédente, ledit élément élastique étant une lame ressort (120, 130, 140).

9. Pince selon l'une des revendications précédentes, au moins une desditesau moins trois mâchoires (12, 13) étant reliée à ladite partie d'actionnement (10) par une articulation essentiellement rigide (121, 131).

10. Pince selon l'une des revendications 7 à 9, ladite au moinsune desdites au moinstrois mâchoires (12,13,14) étant maintenue sur ledit support (2), en rotation autour d'un axe (22, 23, 24) perpendiculaire audit plan de positionnement.

11. Pince selon l'une des revendications précédentes, au moins une desditesau moins trois mâchoires (11, 14) définissant une position de référence pour le positionnement dudit composant électronique (8).

12. Pince selon la revendication précédente, deux desdites au moinstrois mâchoires (11, 14) définissant une position de référence pour le positionnement dudit composant électronique (8).

13. Pince selon l'une desrevendicationsprécédentes, ledit élément mobile (1) étant formé d'une seule pièce.

14. Pince selon l'une desrevendicationsprécédentes, ledit élément mobile (1) étant formé par étampage d'une plaque métallique ou de plusieurs plaques métalliques de sensiblement même épaisseur.

15. Pince selon l'une des revendications précédentes, ladite partie d'actionnement (10) permettant l'actionnement automatique de ladite pince.

16. Pince selon la revendication précédente, ladite partie d'actionnement (10) comprenant une languette (100) pour l'actionnement automatique de ladite pince.

17. Dispositif pour le positionnement de composant électroniques, comprenant une pince (1, 2) selon l'une des revendications précédentes et un actuateur (30) pour l'actionnement automatique de ladite pince (1, 2).

18. Dispositif selon la revendication précédente, comprenant un système de contrôle commandant ledit actuateur (30).

19. Dispositif selon l'une des revendications 17 ou 18, comprenant un élément mécanique (3) pour l'actionnement de ladite pince (1, 2).

20. Dispositif selon la revendication précédente, ledit actuateur (30) permettant le mouvement de ladite pince (1, 2) et/ou dudit élément mécanique (3) pour actionner ladite pince (1, 2) à l'aide dudit élément mécanique (3).

21. Dispositif selon la revendication précédente, ledit actuateur (30) étant un moteur rotatif permettant de tourner ladite pince (1, 2), ledit élément mécanique étant une tige rigide (3) fixée sur ledit dispositif à proximité du périmètre de ladite pince (1, 2).

22. Dispositif selon l'une des revendications 20 ou 21, comprenant des moyens pour le maintien dudit composant électronique (8) sur ladite pince (1, 2) lorsdesmouvementsde ladite pince (1, 2).

23. Dispositif selon la revendication précédente, lesdits moyens pour le maintien dudit composant électronique (8) comprenant des moyens pneumatiques maintenant ledit composant électronique (8) sur ladite pince (1, 2) par aspiration.

24. Dispositif selon la revendication 20, ledit actuateur permettant le mouvement dudit élément mécanique, ladite pince (1, 2) étant fixée sur ledit dispositif.

25. Dispositif selon l'une des revendications 17 à 24, comprenant desélémentsde fixation pour son intégration à une ligne de traitement automatique des composants électroniques.

26. Dispositif selon la revendication précédente, pour le positionnement de composants électroniques (8) traités par ladite ligne de traitement automatique.

27. Méthode pour le positionnement de composants électroniques, comprenant les étapes suivantes:
dépose d'un composant électronique (8) sur une pince de positionnement (1, 2),
positionnement dudit composant électronique (8) dans un plan de positionnement par ladite pince (1, 2) en contact mécanique avec ledit composant électronique (8) en au moinstroispointsd'appui et selon au moinsdeux directions non parallèles entre elles,
prélèvement dudit composant électronique (8) de ladite pince (1,2),
**caractérisée en ce que** le prélèvement dudit composant électronique (8) est effectué au même emplacement que la dépose dudit composant électronique (8).

28. Méthode selon la revendication précédente, ledit positionnement dudit composant électronique (8) étant effectué par actionnement automatique de ladite pince (1, 2) à l'aide d'un élément mécanique (3).

29. Méthode selon la revendication précédente, ledit actionnement de ladite pince (1, 2) étant effectué par le mouvement de ladite pince (1, 2) et/ou dudit élément mécanique (3).

30. Méthode selon la revendication précédente, ledit actionnement de ladite pince (1, 2) étant effectué par rotation de ladite pince (1, 2), ledit élément mécanique (3) étant fixe à proximité du périmètre de ladite pince (1, 2).

31. Méthode selon l'une des revendications 29 ou 30, comprenant en outre l'étape de maintenir ledit composant électronique sur ladite pince (1, 2) lorsdu mouvement de ladite pince (1, 2).

32. Méthode selon la revendication précédente, ledit composant électronique étant maintenu par aspiration.

33. Méthode selon la revendication 29, ledit actionnement de ladite pince (1, 2) étant effectué par le mouvement dudit élément mécanique, ladite pince (1, 2) étant fixe.

## Claims

1. Prehensor for positioning electronic components, comprising a support (2) and a mobile element (1) comprising an actuating part (10),
said mobile element (1) comprising at least three jaws (11, 12, 13, 14) allowing an electronic component (8) to be contacted mechanically in at least three resting points and along at least two directions non parallel to one another for positioning said electronic component (8) relative to said support (2) in a positioning plane,
said prehensor being actuated by a linear movement of said actuating part (10) relative to said support (2) along an actuating axis parallel to the positioning plane.

2. Prehensor according to the preceding claim, at least one of said two non parallel directions being parallel to said actuating axis.

3. Prehensor according to one of the preceding claims, said support (2) allowing the position of said electronic component (8) to be determined along an axis perpendicular to said positioning plane.

4. Prehensor according to the preceding claim, said support (2) comprising a resting surface more or less plane defining said positioning plane.

5. Prehensor according to one of the preceding claims, said mobile element (1) allowing said electronic component to be contacted mechanically in four resting points.

6. Prehensor according to the preceding claim, said mobile element (1) comprising four jaws (11, 12, 13, 14) for mechanically contacting said electronic component (8) in four resting points.

7. Prehensor according to one of the preceding claims, at least one of said at least three jaws (12, 13, 14) being connected to said actuating part (10) by an elastic element (120, 130, 140).

8. Prehensor according to the preceding claim, said elastic element being a spring blade (120, 130, 140).

9. Prehensor according to one of the preceding claims, at least one of said at least three jaws (12, 13) being connected to said actuating part (10) by an essentially rigid articulation (121, 131).

10. Prehensor according to one of the claims 7 to 9, said at least one of said at least three jaws (12, 13, 14) being held on said support (2) in rotation around an axis (22, 23, 24) perpendicular to said positioning plane.

11. Prehensor according to one of the preceding claims, at least one of said three jaws (11, 14) defining a reference position for positioning said electronic component (8).

12. Prehensor according to the preceding claim, two of said at least three jaws (11, 14) defining a reference position for positioning said electronic component (8).

13. Prehensor according to one of the preceding claims, said mobile element (1) being formed of a single piece.

14. Prehensor according to one of the preceding claims, said mobile element (1) being formed by stamping a metallic sheet or several metallic sheets having perceptibly the same thickness.

15. Prehensor according to one of the preceding claims, said actuating part (10) allowing said prehensor to be automatically actuated.

16. Prehensor according to the preceding claim, said actuating part (10) comprising a tongue (100) for automatically actuating said prehensor.

17. Device for positioning electronic components, comprising a prehensor (1, 2) according to one of the preceding claims and an actuator (30) for automatically actuating said prehensor (1, 2).

18. Device according to the preceding claim, comprising a control system controlling said actuator (30).

19. Device according to one of the claim 17 or 18, comprising a mechanical element (3) for actuating said prehensor (1, 2).

20. Device according to the preceding claim, said actuator (30) allowing the movement of said prehensor (1, 2) and/or of said mechanical element (3) for actuating said prehensor (1, 2) by means of said mechanical element (3).

21. Device according to the preceding claim, said actuator (30) being a revolving motor allowing said prehensor (1, 2) to turn, said mechanical element being a rigid rod (3) fastened on said device close to the perimeter of said prehensor (1, 2).

22. Device according to one of the claims 20 or 21, comprising means for holding said electronic component (8) on said prehensor (1, 2) when said prehensor (1, 2) is moving.

23. Device according to the preceding claim, said means for holding said electronic component (8) comprising pneumatic means holding said electronic component (8) on said prehensor (1, 2) through aspiration.

24. Device according to claim 20, said actuator allowing the movement of said mechanical element, said prehensor (1, 2) being fastened on said device.

25. Device according to one of the claims 17 to 24, comprising fastening elements for integrating it into an automatic electronic-component processing line.

26. Device according to the preceding claim for positioning electronic components (8) processed by said automatic processing line.

27. Method for positioning electronic components, comprising the following steps:
placing an electronic component (8) on a positioning prehensor (1, 2),
positioning said electronic component (8) in a positioning plane by said prehensor (1,2) in mechanical contact with said electronic component (8) in at least three resting points and along at least two directions non parallel to one another,
removing said electronic component (8) from said prehensor (1, 2),
**characterized in that** said electronic component (8) is removed at the same place where said electronic component (8) was placed.

28. Method according to the preceding claim, said electronic component (8) being positioned by automatically actuating said prehensor (1, 2) by means of a mechanical element (3).

29. Method according to the preceding claim, said prehensor (1, 2) being actuated by the movement of said prehensor (1, 2) and/or of said mechanical element (3).

30. Method according to the preceding claim, said prehensor (1, 2) being actuated by rotating said prehensor (1, 2), said mechanical element (3) being fastened close to the perimeter of said prehensor (1, 2).

31. Method according to one of the claims 29 or 30, further comprising the step of holding said electronic component on said prehensor (1, 2) when said prehensor (1, 2) are moved.

32. Method according to the preceding claim, said electronic component being held by aspiration.

33. Method according to claim 29, said prehensor (1, 2) being actuated by the movement of said mechanical element, said prehensor (1, 2) being fixed.

## Patentansprüche

1. Greifer zur Positionierung elektronischer Komponenten, umfassend einen Träger (2) und ein mobiles Element (1) mit einem Betätigungsteil (10),
wobei das besagte mobile Element (1) mindestens drei Backen (11, 12, 13, 14) umfasst, welche es einer elektronischen Komponente (8) erlauben, an mindestens drei Ruhepunkte und entlang mindestens zwei zu einander nicht parallelen Richtungen mechanisch kontaktiert zu werden, um die besagte elektronische Komponente (8) in Bezug auf den besagten Träger (2) in einer Positionierungsebene zu positionieren,
wobei der besagte Greifer durch eine lineare Bewegung des besagten Betätigungsteil (10) in Bezug auf den besagten Träger (2) entlang einer zur Positionierungsebene parallelen Betätigungsachse betätigt wird.

2. Greifer gemäss dem vorhergehenden Anspruch, wobei mindestens eine der besagten zwei zueinander nicht parallelen Richtungen parallel zur besagten Betätigungsachse ist.

3. Greifer gemäss einem der vorhergehenden Ansprüche, wobei der besagte Träger (2) die Position der besagten elektronischen Komponente (8) entlang einer zur besagten Positionierungsebene senkrechten Achse zu bestimmen erlaubt.

4. Greifer gemäss dem vorhergehenden Anspruch, wobei der besagte Träger (2) eine mehr oder weniger flache Ruhefläche umfasst, welche die besagte Positionierungsebene definiert.

5. Greifer gemäss einem der vorhergehenden Ansprüche, wobei das besagte mobile Element (1) es erlaubt, eine elektronische Komponente an mindestens vier Ruhepunkte zu kontaktieren.

6. Greifer gemäss dem vorhergehenden Anspruch, wobei das besagte mobile Element (1) vier Backen (11, 12, 13, 14) umfasst, um die besagte elektronische Komponente (8) an vier Ruhepunkten mechanisch zu kontaktieren.

7. Greifer gemäss dem vorhergehenden Anspruch, wobei mindestens eine der besagten mindestens drei Backen (12, 13, 14) mit dem besagten Betätigungsteil (10) durch ein elastisches Element (120, 130, 140) verbunden ist.

8. Greifer gemäss dem vorhergehenden Anspruch, wobei das besagte elastische Element eine Federklinge (120, 130, 140) ist.

9. Greifer gemäss einem der vorhergehenden Ansprüche, wobei mindestens eine der besagten mindestens drei Backen (12, 13) mit dem besagten Betätigungsteil (10) durch ein wesentlich rigides Gelenk (121, 131) verbunden ist.

10. Greifer gemäss einem der Ansprüche 7 bis 9, wobei mindestens eine der besagten mindestens drei Backen (12, 13, 14) auf dem besagten Träger (2) drehend um eine zur besagten Positionierungsebene senkrechten Achse (22, 23, 24) gehalten wird.

11. Greifer gemäss einem der vorhergehenden Ansprüche, wobei mindestens eine der besagten drei Backen (11, 14) eine Referenzposition zur Positionierung der besagten elektronischen Komponente (8) definiert.

12. Greifer gemäss dem vorhergehenden Anspruch, wobei zwei der besagten mindestens drei Backen (11, 14) eine Referenzposition zur Positionierung der besagten elektronischen Komponente (8) definieren.

13. Greifer gemäss einem der vorhergehenden Ansprüche, wobei das besagte mobile Element (1) aus einem einzigen Stück geformt ist.

14. Greifer gemäss einem der vorhergehenden Ansprüche, wobei das besagte mobile Element (1) durch Stanzen einer oder mehrerer metallischer Folien mit einer spürbar gleichen Dicke geformt wird.

15. Greifer gemäss einem der vorhergehenden Ansprüche, wobei der besagte Betätigungsteil (10) es erlaubt, den besagten Greifer automatisch zu betätigen.

16. Greifer gemäss dem vorhergehenden Anspruch, wobei der besagte Betätigungsteil (10) eine Zunge (100) umfasst, um den besagten Greifer automatisch zu betätigen.

17. Vorrichtung zur Positionierung elektronischer Komponenten, mit einem Greifer (1, 2) gemäss einem der vorhergehenden Ansprüche und einem Betätigungselement (30), um den besagten Greifer (1, 2) automatisch zu betätigen.

18. Vorrichtung gemäss dem vorhergehenden Anspruch, mit einem Kontrollsystem zur Kontrolle des besagten Betätigungselements (30).

19. Vorrichtung gemäss einem der Ansprüche 17 oder 18, mit einem mechanischen Element (3), um den besagten Greifer (1, 2) zu betätigen.

20. Vorrichtung gemäss dem vorhergehenden Anspruch, wobei das besagte Betätigungselement (30) die Bewegung des besagten Greifers (1, 2) und/oder des besagten mechanischen Elements (3) erlaubt, um den besagten Greifer (1, 2) mittels des besagten mechanischen Elements (3) zu betätigen.

21. Vorrichtung gemäss dem vorhergehen Anspruch, wobei das besagte Betätigungselement (30) ein Drehmotor ist, der es dem besagten Greifer (1, 2) erlaubt, zu drehen, wobei das besagte mechanische Element ein starrer Stab (3) ist, der auf der besagten Vorrichtung nahe des Perimeters des besagten Greifers (1, 2) befestigt wird.

22. Vorrichtung gemäss einem der Ansprüche 20 oder 21, mit Mitteln um die besagte elektronische Komponente (8) auf dem besagten Greifer (1, 2) zu halten, wenn der besagte Greifer (1, 2) sich bewegt.

23. Vorrichtung gemäss dem vorhergehenden Anspruch, wobei die besagten Mittel um die besagte elektronische Komponente (8) zu halten, pneumatische Mittel enthalten, welche die besagte elektronische Komponente (8) auf dem besagten Greifer (1, 2) durch Aspiration halten.

24. Vorrichtung gemäss Anspruch 20, wobei das Betätigungselement die Bewegung des besagten mechanischen Elements erlaubt, wobei der besagte Greifer (1, 2) auf der besagten Vorrichtung befestigt wird.

25. Vorrichtung gemäss einem der Ansprüche 17 bis 24, mit Befestigungselementen, um in eine automatische Produktionskette für elektronische Komponenten integriert zu werden.

26. Vorrichtung gemäss dem vorhergehenden Anspruch zur Positionierung elektronischer Komponenten (8), die durch die besagte automatische Produktionskette verarbeitet werden.

27. Verfahren zur Positionierung elektronischer Komponenten, mit den folgenden Schritten:
- eine elektronische Komponente (8) wird auf einen Positionierungsgreifer (1, 2) gestellt,
- die besagte elektronische Komponente (8) wird in einer Positionierungsebene durch den besagten Greifer (1, 2) in mechanischem Kontakt mit der besagten elektronischen Komponente (8) an mindestens drei Ruhepunkten und entlang mindestens zwei zu einander nicht parallelen Richtungen positioniert,
- die besagte elektronische Komponente (8) wird vom besagten Greifer (1, 2) weggenommen,
**dadurch gekennzeichnet, dass** die besagte elektronische Komponente (8) an der gleichen Stelle weggenommen wird, wo die besagte elektronische Komponente (8) hingestellt wurde.

28. Verfahren gemäss dem vorhergehenden Anspruch, wobei die besagte elektronische Komponente (8) positioniert wird, indem der besagte Greifer (1, 2) mittels eines mechanischen Elements (3) automatisch betätigt wird.

29. Verfahren gemäss dem vorhergehenden Anspruch, wobei der besagte Greifer (1, 2) durch die Bewegung des besagten Greifers (1, 2) und/oder des besagten mechanischen Elements (3) betätigt wird.

30. Verfahren gemäss dem vorhergehenden Anspruch, wobei der besagte Greifer (1, 2) durch Drehen des besagten Greifers (1, 2) betätigt wird, wobei das besagte mechanische Element (3) nahe dem Perimeter des besagten Greifers (1, 2) befestigt wird.

31. Verfahren gemäss einem der Ansprüche 29 oder 30, mit zudem dem Schritt, dass die besagte elektronische Komponente auf dem besagten Greifer (1, 2) gehalten wird, wenn der besagte Greifer (1, 2) bewegt wird.

32. Verfahren gemäss dem vorhergehenden Anspruch, wobei die besagte elektronische Komponente durch Aspiration gehalten wird.

33. Verfahren gemäss Anspruch 29, wobei der besagte Greifer (1, 2) durch die Bewegung des besagten mechanischen Elements betätigt wird, wobei der besagte Greifer (1, 2) fest ist.
